# EUROPÄISCHE PATENTSCHRIFT

(11) **EP 3 794 640 B1**
(45) Veröffentlichungstag und Bekanntmachung des Hinweises auf die Patenterteilung: **06.07.2022**
(21) Anmeldenummer: 19723412.3
(22) Anmeldetag: 10.05.2019
(51) Int. Cl.: H01L 23/498, H01L 23/373

(54) **VERBUNDANORDNUNG AUS DREI GESTAPELTEN FÜGEPARTNERN**
COMPOSITE ASSEMBLY OF THREE STACKED JOINING PARTNERS
SYSTÈME COMPOSITE COMPOSÉ DE TROIS PIÈCES ASSEMBLÉES EMPILÉES

(30) Priorität: 15.05.2018 DE 102018207537
(43) Veröffentlichungstag der Anmeldung: 24.03.2021
(73) Patentinhaber: Robert Bosch GmbH, 70442 Stuttgart (DE)
(72) Erfinder: SUENNER, Thomas, 70178 Stuttgart (DE); SUESKE, Erik, 72764 Reutlingen (DE); ZIPPRICH, Juergen, 72127 Kusterdingen (DE); SCHIELE, Christian, 89584 Ehingen (DE); KRUTSCH, Andreas, 72108 Rottenburg Am Neckar (DE)
(86) Internationale Anmeldenummer: PCT/EP2019/062059
(87) Internationale Veröffentlichungsnummer: WO 2019/219533

(56) Entgegenhaltungen:
- WO-A2-2004/088725
- US-A1- 2013 134 210

## Beschreibung

Die Erfindung geht aus von einer Verbundanordnung aus drei gestapelten Fügepartnern nach der Gattung des unabhängigen Patentanspruchs 1. Gegenstand der vorliegenden Erfindung ist auch ein Verfahren zum Verbinden eines Schichtstapels aus drei Fügepartnern.

Bauelemente bzw. Fügepartner in der Leistungselektronik werden in der Regel durch einen Reflow-Lötprozess thermisch und elektrisch miteinander verbunden. Um komplexe Aufbauten mit mehreren Bauelementen bzw. Fügepartnern und Lötstellen kostengünstig herstellen zu können, werden sämtliche Verbindungsstellen in einem Schritt gelötet. Während dieses Prozesses kommt es zu einem Volumenschwund um ca. 50% im Lot. Dies führt zu einem Absinken des oberen Bauelements bzw. Fügepartners auf das untere Bauelement bzw. den unteren Fügepartner. In einem Schichtstapel aus drei Fügepartnern, in welchem der obere und untere Fügepartner in ihrer Höhe fixiert sind, ist ein solches Absinken konstruktionsbedingt nicht möglich. Durch den Volumenschwund während des Lötprozesses kann es hierdurch zu einer reduzierten Lot-Anbindungsfläche und/oder zur Ausbildung von Lunkern kommen. Diese kann zu einem erhöhten elektrischen und thermischen Widerstand und dadurch zu reduzierter Funktionalität bis zu reduzierter Lebensdauer führen.

Aus der DE 102 52 577 B4 ist ein Verfahren zum Erzeugen einer Lotverbindung durch kapillaren Lotfluss bekannt. Das offenbarte Verfahren zum Verbinden eines ersten Lötpartners mit einem zweiten Lötpartner umfasst die folgenden Schritte: Platzieren des ersten Lötpartners, des zweiten Lötpartners und eines Lotdepots derart, dass eine Oberfläche des ersten Lötpartners einer Oberfläche des zweiten Lötpartners gegenüberliegt und dass das Lotdepot außerhalb und benachbart zu einem Verbindungsbereich der sich gegenüberliegenden Oberflächen angeordnet ist, wobei sich die gegenüberliegenden Oberflächen der Lötpartner im Verbindungsbereich sind durch das Lot des Lotdepots benetzbar sind, und Erwärmen der Lötpartner und des Lotdepots, so dass das Lotdepot aufschmilzt und durch Kapillarkräfte in den Verbindungsbereich gezogen wird, um die Lötpartner durch eine Verbindungsschicht zu verbinden. Hierbei ist der erste Lötpartner ein Substrat und der zweite Lötpartner ist ein Halbleiterbauelement, welches kleiner als das Substrat ist.

US 2013/134210 A1 (MUTO AYA [JP] ET AL) 30. Mai 2013 (2013-05-30) D1 offenbart eine Verbundanordnung aus drei gestapelten Fügepartnern, welche durch eine obere Lotschicht und durch eine untere Lotschicht stoffschlüssig miteinander verbunden sind.

### Offenbarung der Erfindung

Die Verbundanordnung aus drei gestapelten Fügepartnern mit den Merkmalen des unabhängigen Patentanspruchs 1 sowie das Verfahren zum Verbinden eines Schichtstapels aus drei Fügepartnern mit den Merkmalen des unabhängigen Patentanspruchs 10 haben jeweils den Vorteil, dass ein Volumenschwund während des Lötprozesses in einem Schichtstapel aus drei Fügepartnern durch geeignete Wahl der Lotmittel und der Geometrie der Fügepartner ausgeglichen werden können. Dadurch kann eine hinreichende große Anbindungsfläche der Fügepartner zueinander gewährleistet werden. Die Funktionalität des Aufbaus hinsichtlich elektrischer Anbindung und thermischer Entwärmung wird über alle Toleranzlagen hinweg in vorteilhafter Weise sichergestellt.

Ausführungsformen der vorliegenden Erfindung stellen eine Verbundanordnung aus drei gestapelten Fügepartnern zur Verfügung, welche durch eine obere Lotschicht und durch eine untere Lotschicht stoffschlüssig miteinander verbunden sind, wobei ein oberer Fügepartner und ein unterer Fügepartner in ihrer Höhe fixiert sind und einen vorgegebenen Abstand zueinander aufweisen. Hierbei ist die obere Lotschicht aus einem ersten Lotmittel mit einer ersten Schmelztemperatur zwischen dem oberen Fügepartner und einem mittleren Fügepartner ausgebildet, und die zweite Lotschicht aus einem zweiten Lotmittel mit einer höheren zweiten Schmelztemperatur ist zwischen dem mittleren Fügepartner und dem unteren Fügepartner ausgebildet. Zudem weist der obere Fügepartner eine nach oben offene mit dem ersten Lotmittel gefüllte Lotausgleichsöffnung auf, aus welcher das erste Lotmittel zur Anfüllung des Spalts zwischen dem oberen Fügepartner und dem mittleren Fügepartner in den Spalt nachfließen kann.

Zudem wird ein Verfahren zum Verbinden eines Schichtstapels aus drei Fügepartnern vorgeschlagen, wobei ein oberer Fügepartner und ein unterer Fügepartner in ihrer Höhe fixiert sind und einen vorgegebenen Abstand zueinander aufweisen. Das Verfahren umfasst folgende Schritte: Aufbringen einer ersten Lotpaste, deren erstes Lotmittel eine erste Schmelztemperatur aufweist, auf eine erste lötbare Oberfläche des oberen Fügepartners und auf eine zweite lötbare Oberfläche eines mittleren Fügepartners, so dass ein Spalt zwischen dem oberen Fügepartner und dem mittleren Fügepartner mit der ersten Lotpaste gefüllt ist. Auffüllen einer nach oben offenen Lotausgleichsöffnung im ersten Fügepartner mit der ersten Lotpaste. aufbringen einer zweiten Lotpaste, deren zweites Lotmittel eine höhere zweite Schmelztemperatur aufweist, auf eine dritte lötbare Oberfläche des mittleren Fügepartners und auf eine vierte lötbare Oberfläche des unteren Fügepartners, so dass ein Spalt zwischen dem mittleren Fügepartner und dem unteren Fügepartner mit der zweiten Lotpaste gefüllt ist. Erhitzen des Schichtstapels in einen Reflow-Lötofen auf eine Temperatur, welche höher als die zweite Schmelztemperatur ist, und anschließendes Abkühlen des Schichtstapels, so dass während der Abkühlphase zunächst die unter Lotschicht erstarrt, während die obere Lotschicht noch schmelzflüssig ist, und es zu einem Absinken des mittleren Fügepartners und einer vollflächigen Anbindung des mittleren Fügepartners an den unteren Fügepartner kommt, wobei der nun größere Spalt zwischen dem mittleren Fügepartner und dem oberen Fügepartner mit dem schmelzflüssigen Lotmittel aus der nach oben offenen Lotausgleichsöffnung nachgefüllt wird, so dass es unter Aussparung der Lotausgleichsöffnung zu eine vollflächigen Anbindung des mittleren Fügepartners an den oberen Fügepartner kommt.

Als erstes Lotmittel kann beispielsweise ein Zinn-Silber-Kupfer-Lot (SAC) verwendet werden. Als zweites Lotmittel kann beispielsweise ein Zinn-Kupfer-Lot (SnCu) verwendet werden, welches eine höhere Schmelztemperatur als das Zinn-Silber-Kupfer-Lot (SAC) aufweist und während des Abkühlvorgangs zuerst erstarrt.

Durch die in den abhängigen Ansprüchen aufgeführten Maßnahmen und Weiterbildungen sind vorteilhafte Verbesserungen der im unabhängigen Patentanspruch 1 angegebenen Verbundanordnung aus drei gestapelten Fügepartnern möglich.

Besonders vorteilhaft ist, dass die obere Lotschicht unter Aussparung der Lotausgleichsöffnung vollflächig zwischen einer lötbaren ersten Oberfläche des oberen Fügepartners und einer lötbaren zweiten Oberfläche des mittleren Fügepartners ausgebildet werden kann. Die untere Lotschicht kann vollflächig zwischen einer lötbaren dritten Oberfläche des mittleren Fügepartners und einer lötbaren vierten Oberfläche des unteren Fügepartners ausgebildet werden. Durch die vollflächige stoffschlüssige Anbindung der einzelnen Fügepartner zueinander kann in vorteilhafter Weise eine optimale elektrische und thermische Anbindung ermöglicht werden.

In vorteilhafter Ausgestaltung der Verbundanordnung kann die nach oben offene Lotausgleichsöffnung oberhalb der lötbaren zweiten Oberfläche des mittleren Fügepartners ausgebildet werden und die lötbare erste Oberfläche durchbrechen. Dadurch kann das erste Lotmittel während des Lötvorgangs direkt in den Spalt zwischen dem oberen Fügepartner und dem mittleren Fügepartner nachfließen.

In weiterer vorteilhafter Ausgestaltung der Verbundanordnung kann die nach oben offene Lotausgleichsöffnung ein Volumen aufweisen, welches mindestens doppelt so groß wie ein Volumen des Spalts zwischen dem oberen Fügepartner und dem mittleren Fügepartner ist. Dadurch kann in vorteilhafter Weise sichergestellt werden, dass auch bei einem großen Volumenschwund eine ausreichende Menge an erstem Lotmittel in den Spalt zwischen dem oberen Fügepartner und dem mittleren Fügepartner nachfließen kann.

In weiterer vorteilhafter Ausgestaltung der Verbundanordnung kann der erste Fügepartner beispielsweise ein Stanzgitter sein. Der zweite Fügepartner kann beispielsweise ein DBC-Substrat (DBC: Direct Bonded Copper) sein. Der dritte Fügepartner kann beispielsweise eine Wärmesenke sein.

Hierbei kann eine erste DBC-Kupferstruktur die zweite lötbare Oberfläche des zweiten Fügepartners und eine zweite DBC-Kupferstruktur kann die dritte lötbare Oberfläche des zweiten Fügepartners ausbilden. Das DBC-Substrat kann in vorteilhafter Weise eine sehr gute elektrische Isolation und eine sehr gute thermische Leitfähigkeit zwischen dem Stanzgitter und der Wärmesenke zur Verfügung stellen. Zudem weisen die erste Lotschicht und die zweite Lotschicht im Vergleich mit einer Bondverbindung einen deutlichen niedrigeren elektrischen Widerstand auf.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung eines ersten Ausführungsbeispiels einer erfindungsgemäßen Verbundanordnung aus drei gestapelten Fügepartnern vor einem Lötprozess.
Fig. 2 zeigt eine schematische Schnittdarstellung der erfindungsgemäßen Verbundanordnung aus Fig. 1 nach dem Lötprozess.
Fig. 3 zeigt eine schematische Draufsicht eines Ausschnitts eines Schaltungsmoduls mit einem zweiten Ausführungsbeispiel einer erfindungsgemäßen Verbundanordnung aus drei gestapelten Fügepartnern.
Fig. 4 zeigt eine schematische Schnittdarstellung der erfindungsgemäßen Verbundanordnung aus Fig. 3 entlang der Schnittlinie IV - IV.
Fig. 5 zeigt eine schematische Schnittdarstellung der erfindungsgemäßen Verbundanordnung aus Fig. 3 entlang der Schnittlinie V - V.

### Ausführungsformen der Erfindung

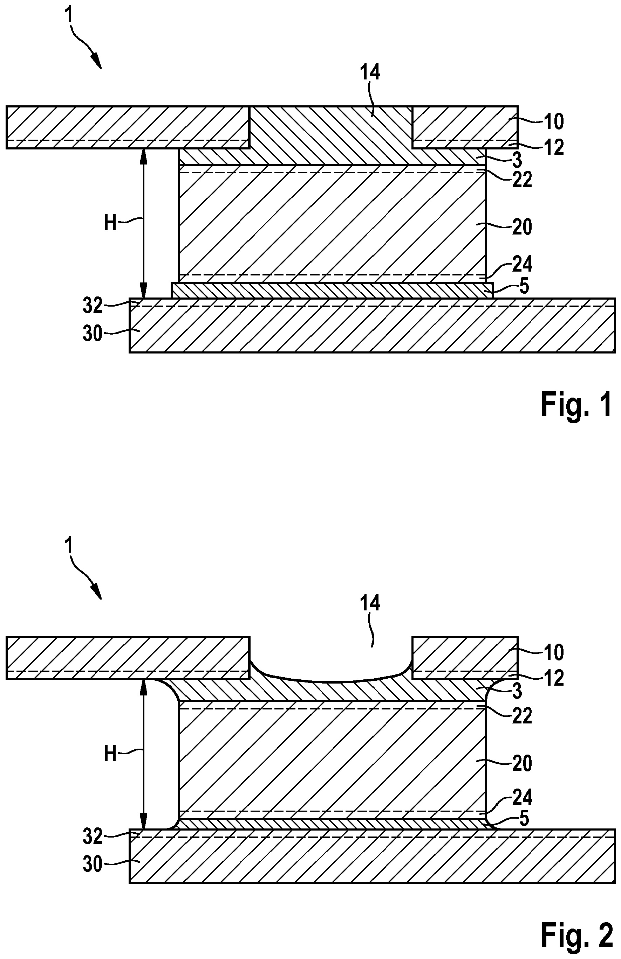

Wie aus Fig. 1 bis 5 ersichtlich ist, umfassen die dargestellten Ausführungsbeispiele einer erfindungsgemäßen Verbundanordnung 1, 1A aus drei gestapelten Fügepartnern 10, 20, 30 jeweils einen oberen Fügepartner 10, einen mittleren Fügepartner 20 und einen unteren Fügepartner 30, welche durch eine obere Lotschicht 3 und durch eine untere Lotschicht 5 stoffschlüssig miteinander verbunden. Hierbei sind der obere Fügepartner 10 und der untere Fügepartner 30 in ihrer Höhe fixiert und weisen einen vorgegebenen Abstand H zueinander auf. Die obere Lotschicht 3 aus einem ersten Lotmittel mit einer ersten Schmelztemperatur ist zwischen dem oberen Fügepartner 10 und dem mittleren Fügepartner 20 ausgebildet. Die zweite Lotschicht 5 aus einem zweiten Lotmittel mit einer höheren zweiten Schmelztemperatur ist zwischen dem mittleren Fügepartner 20 und dem unteren Fügepartner 30 ausgebildet. Zudem weist der obere Fügepartner 10 eine nach oben offene mit dem ersten Lotmittel gefüllte Lotausgleichsöffnung 14 auf, aus welcher das erste Lotmittel zur Anfüllung des Spalts zwischen dem oberen Fügepartner 10 und dem mittleren Fügepartner 20 in den Spalt nachfließt.

Wie aus Fig. 1 bis 5 weiter ersichtlich ist, ist die obere Lotschicht 3 unter Aussparung der Lotausgleichsöffnung 14 vollflächig zwischen einer lötbaren ersten Oberfläche 12 des oberen Fügepartners 10 und einer lötbaren zweiten Oberfläche 22 des mittleren Fügepartners 20 ausgebildet. Die untere Lotschicht 5 ist vollflächig zwischen einer lötbaren dritten Oberfläche 24 des mittleren Fügepartners 20 und einer lötbaren vierten Oberfläche 32 des unteren Fügepartners 30 ausgebildet.

Wie aus Fig. 1 bis 5 weiter ersichtlich ist, ist die nach oben offene Lotausgleichsöffnung 14 in den dargestellten Ausführungsbeispielen oberhalb der lötbaren zweiten Oberfläche 22 des mittleren Fügepartners 20 ausgebildet ist und durchbricht die lötbare erste Oberfläche 12 des oberen Fügepartners 10. Zudem weist die nach oben offene Lotausgleichsöffnung 14 ein Volumen auf, welches mindestens doppelt so groß wie ein Volumen des Spalts zwischen dem oberen Fügepartner 10 und dem mittleren Fügepartner 20 ist.

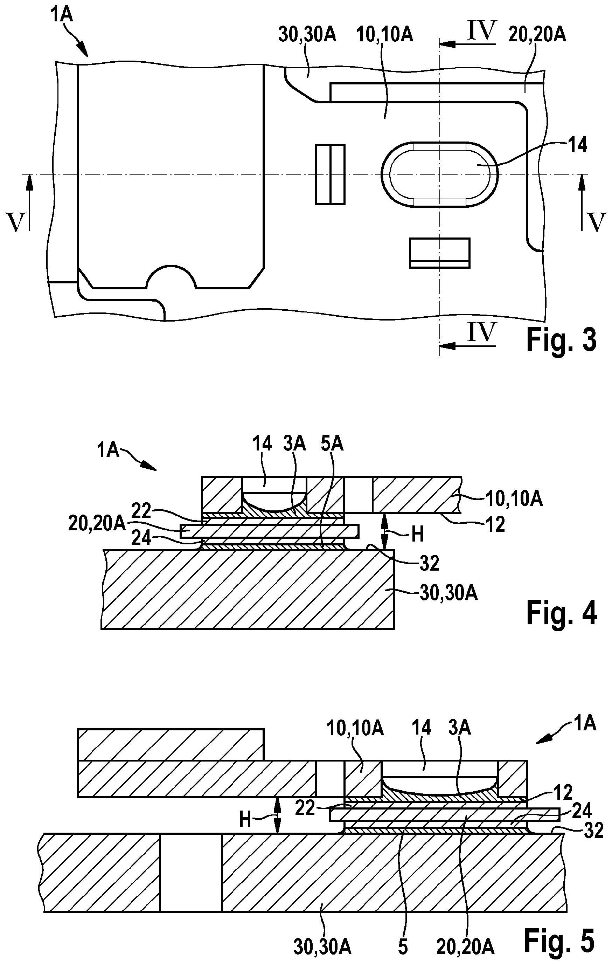

Wie aus Fig. 3 bis 5 weiter ersichtlich ist, ist das dargestellte zweite Ausführungsbeispiel der erfindungsgemäßen Verbundanordnung 1A aus drei Fügepartnern 10, 20, 30 Teil eines Schaltungsmoduls. Hierbei ist der erste Fügepartner 10 ein Stanzgitter 10A, der zweite Fügepartner 20 ist ein DBC-Substrat 20A (DBC: Direct Bonded Copper) und der dritte Fügepartner 30 ist eine Wärmesenke 30A. Zudem bildet eine erste DBC-Kupferstruktur 22A die zweite lötbare Oberfläche 22 des zweiten Fügepartners 20 aus, und eine zweite DBC-Kupferstruktur 24A bildet die dritte lötbare Oberfläche 22 des zweiten Fügepartners 20 aus.

Ausführungsformen des erfindungsgemäßen Verfahrens zum Verbinden eines Schichtstapels aus drei Fügepartnern 10, 20, 30, bei welchem ein oberer Fügepartner 10 und ein unterer Fügepartner 30 in ihrer Höhe fixiert sind und einen vorgegebenen Abstand H zueinander aufweisen, umfassen folgende Schritte: Aufbringen einer ersten Lotpaste, deren erstes Lotmittel eine erste Schmelztemperatur aufweist, auf eine erste lötbare Oberfläche 12 des oberen Fügepartners 10 und auf eine zweite lötbare Oberfläche 22 eines mittleren Fügepartners 20, so dass ein Spalt zwischen dem oberen Fügepartner 10 und dem mittleren Fügepartner 20 mit der ersten Lotpaste gefüllt ist. Auffüllen einer nach oben offenen Lotausgleichsöffnung 14 im ersten Fügepartner 10 mit der ersten Lotpaste. Aufbringen einer zweiten Lotpaste, deren zweites Lotmittel eine höhere zweite Schmelztemperatur aufweist, auf eine dritte lötbare Oberfläche 24 des mittleren Fügepartners 20 und auf eine vierte lötbare Oberfläche 32 des unteren Fügepartners 30, so dass ein Spalt zwischen dem mittleren Fügepartner 20 und dem unteren Fügepartner (30) mit der zweiten Lotpaste gefüllt ist. Fig.1 zeigt den so vorbereiteten Schichtstapels aus drei Fügepartnern 10, 20, 30 vor dem Lötvorgang in einem Reflow-Lötofen. Wie aus Fig. 1 weiter ersichtlich ist, sind der Spalt zwischen dem oberen Fügepartner 10 und dem mittleren Fügepartner 20 sowie der Spalt zwischen dem unteren Fügepartner 30 und dem mittleren Fügepartner 20 im dargestellten Ausführungsbeispiel jeweils vollständig mit der korrespondierenden Lotpaste gefüllt. Auch die nach oben offenen Lotausgleichsöffnung 14 im ersten Fügepartner 10 ist im dargestellten Ausführungsbeispiel vollständig mit der ersten Lotpaste gefüllt.

Der Schichtstapel wird in einen Reflow-Lötofen auf eine Temperatur erhitzt, welche höher als die zweite Schmelztemperatur ist. Anschließend wird der Schichtstapel abgekühlt, so dass während der Abkühlphase zunächst die unter Lotschicht 5 erstarrt, während die obere Lotschicht 3 noch schmelzflüssig ist, und es zu einem Absinken des mittleren Fügepartners 20 und einer vollflächigen Anbindung des mittleren Fügepartners 20 an den unteren Fügepartner 30 kommt. Der nun größere Spalt zwischen dem mittleren Fügepartner 20 und dem oberen Fügepartner 10 wird mit dem schmelzflüssigen Lotmittel aus der nach oben offenen Lotausgleichsöffnung 14 nachgefüllt, so dass es unter Aussparung der Lotausgleichsöffnung 14 zu einer vollflächigen Anbindung des mittleren Fügepartners 20 an den oberen Fügepartner 10 kommt.

Fig. 2 zeigt den Schichtstapel aus drei Fügepartnern 10, 20, 30 nach dem Lötvorgang. Wie aus Fig. 2 weiter ersichtlich ist, ist das vor dem Lötvorgang in die Lotausgleichsöffnung 14 eingebrachte erste Lotmittel nahezu vollständig in den Spalt zwischen dem oberen Fügepartner 10 und dem mittleren Fügepartner 20 geflossen, um den Volumenverlust des ersten Lotmittels und das Absinken des mittleren Fügepartners 20 während des Lötvorgangs im Reflow-Lötofen auszugleichen.

In den dargestellten Ausführungsbeispielen wird als erstes Lotmittel für die obere Lotschicht 3 ein Zinn-Silber-Kupfer-Lot (SAC) verwendet. Als zweites Lotmittel für die untere Lotschicht 5 wird in den dargestellten Ausführungsbeispielen ein Zinn-Kupfer-Lot (SnCu) verwendet, welches eine höhere Schmelztemperatur als das Zinn-Silber-Kupfer-Lot (SAC) der ersten Lotschicht 3 aufweist. Dadurch erstarrt das zweite Lotmittel der unteren Lotschicht 5 während des Abkühlvorgangs vor dem ersten Lotmittel der oberen Lotschicht 3.

Ausführungsformen der vorliegenden Erfindung können beispielsweise für alle Leistungsmodule in Invertern verwendet werden und generell in gemoldeten Schaltmodulen, auch mit reduzierter Leistung eingesetzt werden.

## Patentansprüche

1. Verbundanordnung (1, 1A) aus drei gestapelten Fügepartnern (10, 20, 30), welche durch eine obere Lotschicht (3) und durch eine untere Lotschicht (5) stoffschlüssig miteinander verbunden sind, wobei ein oberer Fügepartner (10) und ein unterer Fügepartner (30) in ihrer Höhe fixiert sind und einen vorgegebenen Abstand (H) zueinander aufweisen, wobei die obere Lotschicht (3) aus einem ersten Lotmittel mit einer ersten Schmelztemperatur zwischen dem oberen Fügepartner (10) und einem mittleren Fügepartner (20) ausgebildet ist, und die zweite Lotschicht (5) aus einem zweiten Lotmittel mit einer höheren zweiten Schmelztemperatur zwischen dem mittleren Fügepartner (20) und dem unteren Fügepartner (30) ausgebildet ist, und wobei der obere Fügepartner (10) eine nach oben offene mit dem ersten Lotmittel gefüllte Lotausgleichsöffnung (14) aufweist, aus welcher das erste Lotmittel zur Anfüllung des Spalts zwischen dem oberen Fügepartner (10) und dem mittleren Fügepartner (20) in den Spalt nachfließen kann.

2. Verbundanordnung (1, 1A) nach Anspruch 1, **dadurch gekennzeichnet, dass** die obere Lotschicht (3) unter Aussparung der Lotausgleichsöffnung (14) vollflächig zwischen einer lötbaren ersten Oberfläche (12) des oberen Fügepartners (10) und einer lötbaren zweiten Oberfläche (22) des mittleren Fügepartners (20) ausgebildet ist.

3. Verbundanordnung (1, 1A) nach Anspruch 1 oder 2, **dadurch gekennzeichnet, dass** die untere Lotschicht (5) vollflächig zwischen einer lötbaren dritten Oberfläche (24) des mittleren Fügepartners (20) und einer lötbaren vierten Oberfläche (32) des unteren Fügepartners (30) ausgebildet ist.

4. Verbundanordnung (1, 1A) nach Anspruch 2 oder 3, **dadurch gekennzeichnet, dass** die nach oben offene Lotausgleichsöffnung (14) oberhalb der lötbaren zweiten Oberfläche (22) des mittleren Fügepartners (20) ausgebildet ist und die lötbare erste Oberfläche (12) durchbricht.

5. Verbundanordnung (1, 1A) nach einem der Ansprüche 1 bis 4, **dadurch gekennzeichnet, dass** die nach oben offene Lotausgleichsöffnung (14) ein Volumen aufweist, welches mindestens doppelt so groß wie ein Volumen des Spalts zwischen dem oberen Fügepartner (10) und dem mittleren Fügepartner (20) ist.

6. Verbundanordnung (1, 1A) nach einem der Ansprüche 1 bis 5, **dadurch gekennzeichnet, dass** der erste Fügepartner (10) ein Stanzgitter (10A) ist.

7. Verbundanordnung (1, 1A) nach einem der Ansprüche 1 bis 6, **dadurch gekennzeichnet, dass** der zweite Fügepartner (20) ein DBC-Substrat (20A) ist.

8. Verbundanordnung (1, 1A) nach Anspruch 7, **dadurch gekennzeichnet, dass** eine erste DBC-Kupferstruktur (22A) die zweite lötbare Oberfläche (22) des zweiten Fügepartners (20) und eine zweite DBC-Kupferstruktur (24A) die dritte lötbare Oberfläche (22) des zweiten Fügepartners (20) ausbildet.

9. Verbundanordnung (1, 1A) nach einem der Ansprüche 1 bis 8, **dadurch gekennzeichnet, dass** der dritte Fügepartner (30) eine Wärmesenke (30A) ist.

10. Verfahren zum Verbinden eines Schichtstapels aus drei Fügepartnern (10, 20, 30), wobei ein oberer Fügepartner (10) und ein unterer Fügepartner (30) in ihrer Höhe fixiert sind und einen vorgegebenen Abstand (H) zueinander aufweisen, mit folgenden Schritten:
Aufbringen einer ersten Lotpaste, deren erstes Lotmittel eine erste Schmelztemperatur aufweist, auf eine erste lötbare Oberfläche (12) des oberen Fügepartners (10) und auf eine zweite lötbare Oberfläche (22) eines mittleren Fügepartners (20), so dass ein Spalt zwischen dem oberen Fügepartner (10) und dem mittleren Fügepartner (20) mit der ersten Lotpaste gefüllt ist,
Auffüllen einer nach oben offenen Lotausgleichsöffnung (14) im ersten Fügepartner (10) mit der ersten Lotpaste,
Aufbringen einer zweiten Lotpaste, deren zweites Lotmittel eine höhere zweite Schmelztemperatur aufweist, auf eine dritte lötbare Oberfläche (24) des mittleren Fügepartners (20) und auf eine vierte lötbare Oberfläche (32) des unteren Fügepartners (30), so dass ein Spalt zwischen dem mittleren Fügepartner (20) und dem unteren Fügepartner (30) mit der zweiten Lotpaste gefüllt ist,
Erhitzen des Schichtstapels in einen Reflow-Lötofen auf eine Temperatur, welche höher als die zweite Schmelztemperatur ist, und
Anschließendes Abkühlen des Schichtstapels, so dass während der Abkühlphase zunächst die unter Lotschicht (5) erstarrt, während die obere Lotschicht (3) noch schmelzflüssig ist, und es zu einem Absinken des mittleren Fügepartners (20) und einer vollflächigen Anbindung des mittleren Fügepartners (20) an den unteren Fügepartner (30) kommt, wobei der nun größere Spalt zwischen dem mittleren Fügepartner (20) und dem oberen Fügepartner (10) mit dem schmelzflüssigen Lotmittel aus der nach oben offenen Lotausgleichsöffnung (14) nachgefüllt wird, so dass es unter Aussparung der Lotausgleichsöffnung (14) zu eine vollflächigen Anbindung des mittleren Fügepartners (20) an den oberen Fügepartner (10) kommt.

## Claims

1. Composite arrangement (1, 1A) of three stacked parts (10, 20, 30) to be joined, which are materially bonded to one another by an upper solder layer (3) and by a lower solder layer (5), wherein an upper part (10) to be joined and a lower part (30) to be joined are fixed in their height and have a predefined spacing (H) from one another, wherein the upper solder layer (3) is formed from a first solder with a first melting temperature between the upper part (10) to be joined and a middle part (20) be joined, and the second solder layer (5) is formed from a second solder with a higher, second melting temperature between the middle part (20) to be joined and the lower part (30) to be joined, and wherein the upper part (10) to be joined has an upwardly open solder equalization opening (14) which is filled with the first solder and out of which the first solder can continue to flow into the gap in order to fill the gap between the upper part (10) to be joined and the middle part (20) to be joined.

2. Composite arrangement (1, 1A) according to Claim 1, **characterized in that** the upper solder layer (3) is formed below the cutout of the solder equalization opening (14) over the entire surface area between a solderable first surface (12) of the upper part (10) to be joined and a solderable second surface (22) of the middle part (20) to be joined.

3. Composite arrangement (1, 1A) according to Claim 1 or 2, **characterized in that** the lower solder layer (5) is formed over the entire surface area between a solderable third surface (24) of the middle part (20) to be joined and a solderable fourth surface (32) of the lower part (30) to be joined.

4. Composite arrangement (1, 1A) according to Claim 2 or 3, **characterized in that** the upwardly open solder equalization opening (14) is formed above the solderable second surface (22) of the middle part (20) to be joined and penetrates the solderable first surface (12).

5. Composite arrangement (1, 1A) according to one of Claims 1 to 4, **characterized in that** the upwardly open solder equalization opening (14) has a volume which is at least twice the size of a volume of the gap between the upper part (10) to be joined and the middle part (20) be joined.

6. Composite arrangement (1, 1A) according to one of Claims 1 to 5, **characterized in that** the first part (10) to be joined is a leadframe (10A).

7. Composite arrangement (1, 1A) according to one of Claims 1 to 6, **characterized in that** the second part (20) to be joined is a DBC substrate (20A).

8. Composite arrangement (1, 1A) according to Claim 7, **characterized in that** a first DBC copper structure (22A) forms the second solderable surface (22) of the second part (20) to be joined and a second DBC copper structure (24A) forms the third solderable surface (22) of the second part (20) to be joined.

9. Composite arrangement (1, 1A) according to one of Claims 1 to 8, **characterized in that** the third part (30) to be joined is a heat sink (30A).

10. Method for connecting a layer stack of three parts (10, 20, 30) to be joined, wherein an upper part (10) to be joined and a lower part (30) to be joined are fixed in their height and have a predefined spacing (H) from one another, said method having the following steps:
Applying a first solder paste, the first solder of which has a first melting temperature, to a first solderable surface (12) of the upper part (10) to be joined and to a second solderable surface (22) of a middle part (20) to be joined, with the result that a gap between the upper part (10) to be joined and the middle part (20) to be joined is filled with the first solder paste,
Filling an upwardly open solder equalization opening (14) in the first part (10) to be joined with the first solder paste,
Applying a second solder paste, the second solder of which has a higher, second melting temperature, to a third solderable surface (24) of the middle part (20) to be joined and to a fourth solderable surface (32) of the lower part (30) to be joined, with the result that a gap between the middle part (20) to be joined and the lower part (30) to be joined is filled with the second solder paste,
Heating the layer stack in a reflow soldering oven to a temperature higher than the second melting temperature, and
Subsequently cooling the layer stack, with the result that, during the cooling phase, first of all the lower solder layer (5) solidifies while the upper solder layer (3) is still molten, and the middle part (20) to be joined sinks and the middle part (20) to be joined bonds to the lower part (30) to be joined over their entire surface area, wherein the now larger gap between the middle part (20) to be joined and the upper part (10) to be joined is replenished with the molten solder out of the upwardly open solder equalization opening (14), such that the middle part (20) to be joined bonds to the upper part (10) to be joined over their entire surface area below the cutout of the solder equalization opening (14).

## Revendications

1. Agencement composite (1, 1A) composé de trois partenaires d'assemblage empilés (10, 20, 30), qui sont reliés entre eux par liaison de matière par une couche de brasage supérieure (3) et par une couche de brasage inférieure (5), un partenaire d'assemblage supérieur (10) et un partenaire d'assemblage inférieur (30) étant fixés dans leur hauteur et présentant une distance prédéterminée (H) l'un par rapport à l'autre, la couche de brasage supérieure (3) étant formée d'un premier agent de brasage ayant une première température de fusion entre le partenaire d'assemblage supérieur (10) et un partenaire d'assemblage intermédiaire (20), et la deuxième couche de brasage (5) étant formée d'un deuxième agent de brasage ayant une deuxième température de fusion plus élevée entre le partenaire d'assemblage intermédiaire (20) et le partenaire d'assemblage inférieur (30), et le partenaire d'assemblage supérieur (10) présentant une ouverture d'équilibrage de brasage (14) ouverte vers le haut, remplie avec le premier agent de brasage, à partir de laquelle le premier agent de brasage peut s'écouler dans l'interstice entre le partenaire d'assemblage supérieur (10) et le partenaire d'assemblage intermédiaire (20) pour remplir l'interstice.

2. Agencement composite (1, 1A) selon la revendication 1, **caractérisé en ce que** la couche de brasage supérieure (3) est formée sur toute la surface entre une première surface brasable (12) du partenaire d'assemblage supérieur (10) et une deuxième surface brasable (22) du partenaire d'assemblage intermédiaire (20), en laissant libre l'ouverture d'équilibrage de brasage (14).

3. Agencement composite (1, 1A) selon la revendication 1 ou 2, **caractérisé en ce que** la couche de brasage inférieure (5) est formée sur toute la surface entre une troisième surface brasable (24) du partenaire d'assemblage intermédiaire (20) et une quatrième surface brasable (32) du partenaire d'assemblage inférieur (30).

4. Agencement composite (1, 1A) selon la revendication 2 ou 3, **caractérisé en ce que** l'ouverture d'équilibrage de brasage (14) ouverte vers le haut est formée au-dessus de la deuxième surface brasable (22) du partenaire d'assemblage intermédiaire (20) et traverse la première surface brasable (12).

5. Agencement composite (1, 1A) selon l'une quelconque des revendications 1 à 4, **caractérisé en ce que** l'ouverture d'équilibrage de brasage (14) ouverte vers le haut présente un volume qui est au moins deux fois plus grand qu'un volume de l'interstice entre le partenaire d'assemblage supérieur (10) et le partenaire d'assemblage intermédiaire (20).

6. Agencement composite (1, 1A) selon l'une quelconque des revendications 1 à 5, **caractérisé en ce que** le premier partenaire d'assemblage (10) est une grille de découpage (10A).

7. Agencement composite (1, 1A) selon l'une quelconque des revendications 1 à 6, **caractérisé en ce que** le deuxième partenaire d'assemblage (20) est un substrat DBC (20A).

8. Agencement composite (1, 1A) selon la revendication 7, **caractérisé en ce qu'**une première structure de cuivre DBC (22A) forme la deuxième surface brasable (22) du deuxième partenaire d'assemblage (20) et une deuxième structure de cuivre DBC (24A) forme la troisième surface brasable (22) du deuxième partenaire d'assemblage (20).

9. Agencement composite (1, 1A) selon l'une quelconque des revendications 1 à 8, **caractérisé en ce que** le troisième partenaire d'assemblage (30) est un dissipateur thermique (30A).

10. Procédé de liaison d'un empilement de couches composé de trois partenaires d'assemblage (10, 20, 30), un partenaire d'assemblage supérieur (10) et un partenaire d'assemblage inférieur (30) étant fixés dans leur hauteur et présentant une distance prédéterminée (H) l'un par rapport à l'autre, comprenant les étapes suivantes :
l'application d'une première pâte de brasage, dont le premier agent de brasage présente une première température de fusion, sur une première surface brasable (12) du partenaire d'assemblage supérieur (10) et sur une deuxième surface brasable (22) d'un partenaire d'assemblage intermédiaire (20), de telle sorte qu'un interstice entre le partenaire d'assemblage supérieur (10) et le partenaire d'assemblage intermédiaire (20) est rempli avec la première pâte de brasage,
le remplissage d'une ouverture d'équilibrage de brasage (14) ouverte vers le haut dans le premier partenaire d'assemblage (10) avec la première pâte de brasage,
l'application d'une deuxième pâte de brasage, dont le deuxième agent de brasage présente une deuxième température de fusion plus élevée, sur une troisième surface brasable (24) du partenaire d'assemblage intermédiaire (20) et sur une quatrième surface brasable (32) du partenaire d'assemblage inférieur (30), de telle sorte qu'un interstice entre le partenaire d'assemblage intermédiaire (20) et le partenaire d'assemblage inférieur (30) est rempli avec la deuxième pâte de brasage,
le chauffage de l'empilement de couches dans un four de brasage par refusion à une température, qui est supérieure à la deuxième température de fusion, puis le refroidissement de l'empilement de couches de telle sorte que, pendant la phase de refroidissement, la couche de brasage inférieure (5) se solidifie en premier, tandis que la couche de brasage supérieure (3) est encore en fusion, et ceci résulte en un affaissement du partenaire d'assemblage intermédiaire (20) et en une liaison sur toute la surface du partenaire d'assemblage intermédiaire (20) avec le partenaire d'assemblage inférieur (30), l'interstice alors plus grand entre le partenaire d'assemblage intermédiaire (20) et le partenaire d'assemblage supérieur (10) étant rempli avec l'agent de brasage en fusion provenant de l'ouverture d'équilibrage de brasage (14) ouverte vers le haut, de telle sorte que ceci résulte en une liaison sur toute la surface du partenaire d'assemblage intermédiaire (20) sur le partenaire d'assemblage supérieur (10) en laissant libre l'ouverture d'équilibrage de brasage (14).
